# FASCICULE DE BREVET EUROPEEN

(11) **EP 0 694 965 B1**
(45) Date de publication et mention de la délivrance du brevet: **02.06.1999**
(21) Numéro de dépôt: 95410073.1
(22) Date de dépôt: 25.07.1995
(51) Int. Cl.: H01L 23/31, H01L 21/48, H01L 21/56

(54) **Boîtier BGA de circuit intégré et procédé de réalisation d'un tel boîtier**
BGA Gehäuse für integrierte Schaltungen und Verfahren zu ihrer Herstellung
BGA package for integrated circuits and method for manufacturing

(30) Priorité: 26.07.1994 FR 9409490
(43) Date de publication de la demande: 31.01.1996
(73) Titulaire: STMicroelectronics S.A., 94250 Gentilly (FR)
(72) Inventeur: Moscicki, Jean-Pierre, F-38950 Saint Martin le Vinoux (FR)
(74) Mandataire: de Beaumont, Michel

(56) Documents cités:
- EP-A- 0 536 418
- FR-A- 2 684 802
- US-A- 5 216 278
- PATENT ABSTRACTS OF JAPAN vol. 18 no. 336 (E-1568) ,24 Juin 1994 & JP-A-06 085005 (SONY CORP) 25 Mars 1994,
- PATENT ABSTRACTS OF JAPAN vol. 18 no. 364 (E-1575) ,8 Juillet 1994 & JP-A-06 097666 (HITACHI LTD.) 8 Avril 1994,
- PATENT ABSTRACTS OF JAPAN vol. 14 no. 190 (E-0918) ,18 Avril 1990 & JP-A-02 037761 (NEC CORP.) 7 Février 1990,
- PATENT ABSTRACTS OF JAPAN vol. 6, no. 160 (E-126) 21 Août 1982 & JP-A-57 079 652 (NEC CORP) 18 Mai 1982

## Description

La présente invention concerne un boîtier de circuit intégré et un procédé de réalisation d'un tel boîtier. Elle s'applique plus particulièrement la réalisation d'un boîtier, constitué à partir d'une plaquette isolante sur une surface supérieure de laquelle est montée une puce de circuit intégré qui est ensuite encapsulée. Des bornes sur une surface supérieure de la puce sont reliées à des plots de connexion sur la face supérieure de la plaquette. Une face inférieure de la plaquette comprend un réseau, de préférence régulier, de bossages ou billes conductrices de raccordement. Chaque bille de raccordement est reliée à l'un des plots de connexion sur la face supérieure de la plaquette par l'intermédiaire d'un trou métallisé. Ce type de boîtier est communément appelé un boîtier BGA (Ball Grid Array). JP-A-57-79652 prévoit un boîtier de ce type ayant des trous traversants remplis du matériau d'encapsulation. JP-A-6-85005 prévoit une structure ayant, sous la puce, des trous traversants remplis de resine ; les trous n'assurent pas un report de connexion électrique.

Dans un premier type de boîtier BGA, les bossages de raccordement sont constitués en un matériau dur, généralement en cuivre. L'implantation du boîtier sur une carte électronique s'effectue alors avec interposition d'une goutte de soudure, par exemple à l'étain, entre chaque bossage et une borne en cuivre de la carte électronique. Un boîtier de ce type est décrit dans la demande de brevet européen numéro EP-A-0 536 418. Un inconvénient d'un tel boîtier est qu'il impose de réaliser le réseau de bossage durant la phase de réalisation de la plaquette destinée à recevoir la puce de circuit intégré. Un autre inconvénient est que l'implantation du boîtier sur une carte électronique est particulièrement délicate dans la mesure où elle impose de disposer des gouttes de soudure à l'étain entre chaque bossage et la borne de la carte avec laquelle ce bossage doit être connecté. Un autre inconvénient est que ces bossages en cuivre écartent le boîtier de la carte électronique, ce qui nuit à la tenue mécanique du boîtier sur la carte.

Pour faciliter l'implantation d'un boîtier BGA, on préfère avoir recours à des billes de raccordement qui sont directement en un matériau de soudure, par exemple à l'étain. Ces billes de raccordement sont donc destinées à fondre lors de l'implantation du boîtier pour assurer une connexion optimale entre le boîtier et la carte électronique.

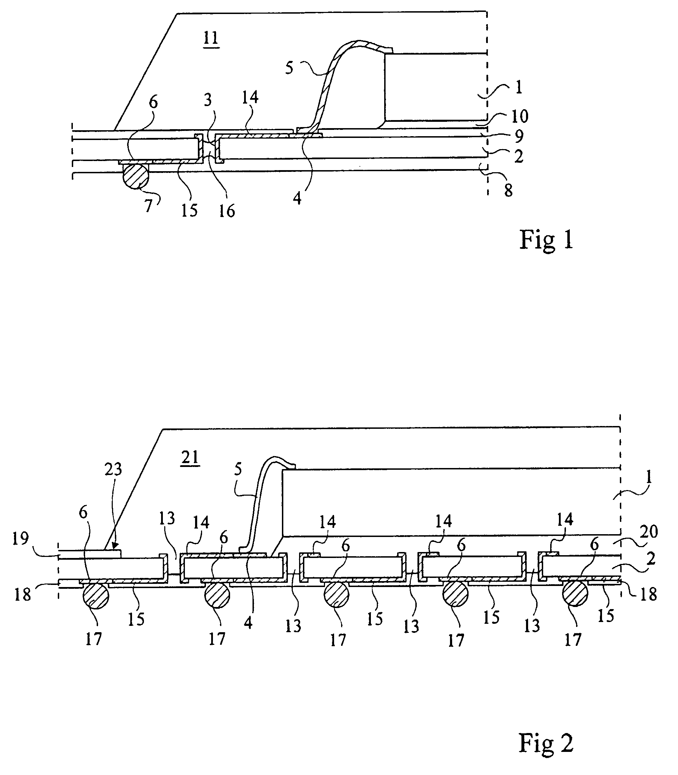

La figure 1 représente un exemple de structure classique d'un boîtier de ce type auquel s'applique la présente invention. La représentation de cette figure montre partiellement et en coupe un tel boîtier au niveau d'un bord d'une puce 1 de circuit intégré. La puce 1 est placée sur une face supérieure d'une plaquette isolante 2, par exemple du type utilisé pour former des cartes de circuit imprimé. La plaquette 2 est pourvue de trous métallisés 3 reliés individuellement, sur la face supérieure de la plaquette 2 et par l'intermédiaire de pistes conductrices 14, à des plots de connexion 4, eux-mêmes connectés par des fils de liaison 5 à des bornes de la puce 1. Les trous métallisés 3 sont reliés, sur une face inférieure de la plaquette 2 et par l'intermédiaire de pistes conductrices 15 et de plots 6, à des billes 7 qui constituent les contacts de raccordement du boîtier. Chacune des faces de la plaquette 2 est recouverte d'une couche d'isolement, respectivement 8 et 9, ouverte aux emplacements des plots, respectivement 6 et 4. Une couche de colle 10 est généralement interposée entre la puce 1 et la couche supérieure d'isolement 9. L'ensemble est revêtu, en face supérieure, d'une résine époxy d'encapsulation 11.

La réalisation d'un tel boîtier fait appel à deux phases de fabrication distinctes. Une première phase concerne la réalisation de la plaquette 2 destinée à recevoir la puce 1 de circuit intégré. Une deuxième phase de montage concerne l'assemblage de la puce 1 et l'encapsulation.

La première phase comporte généralement les étapes suivantes. On part d'une plaquette isolante 2 métallisée sur ses deux faces. La métallisation est, par exemple, en cuivre. Une première étape consiste à réaliser, mécaniquement, les trous de communication entre les deux faces de la plaquette et à métalliser ces trous. Une deuxième étape consiste à réaliser, au moyen d'une résine photosensible, un masque de définition du motif des pistes conductrices 14 et 15 et des plots 4 et 6 en faces supérieure et inférieure de la plaquette 2. Une troisième étape consiste à effectuer une gravure, par exemple chimique, selon le motif défini par le masque pour obtenir, dans les métallisations des faces supérieure et inférieure de la plaquette 2, les pistes conductrices 14 et 15 et les plots de connexion 4 et 6. Le masque est alors ôté pour rendre accessibles les pistes conductrices 14 et 15 et les plots 4 et 6. Une quatrième étape consiste à réaliser les couches d'isolement 8 et 9 pour protéger les pistes 14 et 15 de manière définitive. Ces couches d'isolement 8 et 9 sont constituées de couches de vernis, ou résine, isolant et photosensible qui sont ouvertes, par exemple par photolithographie, au droit des plots de connexion 4 et 6. Dans une cinquième étape, on effectue généralement un dépôt électrolytique hautement conducteur, par exemple de nickel et d'or sur les plots 4 et 6.

La plaquette 2 est alors terminée et prête à recevoir une puce 1 de circuit intégré.

La deuxième phase comporte généralement les étapes suivantes. Une première étape consiste à coller la puce 1 sur la face supérieure de la plaquette 2. Une deuxième étape consiste à câbler la puce, c'est-à-dire à relier des bornes de la face supérieure de la puce 1 aux plots de connexion 4, par exemple au moyen de fils d'or 5. Une troisième étape consiste à encapsuler la puce 1 dans une résine époxy 11. Cette encapsulation est, par exemple, réalisée par moulage. Une quatrième et dernière étape consiste à réaliser les billes de raccordement 7 sur les plots de connexion 6 en face inférieure de la plaquette 2. Ces billes sont constituées de billes en un matériau de soudure, par exemple à l'étain, pour pourvoir être fondues lorsque le boîtier terminé est implanté sur une carte électronique.

Un problème que l'on rencontre dans ce type de boîtier est que les couches d'isolement 8 et 9 qui sont déposées sur les faces de la plaquette 2 ne comblent pas les trous métallisés 3 qui traversent la plaquette 2. Cela entraîne la formation, dans ces trous, de poches d'air 16 qui sont prisonnières entre les deux couches d'isolement 8 et 9 et qui sont inévitablement chargées d'humidité. La présence de ces bulles est néfaste. En effet, ces bulles se dilatent, sous l'effet de la chaleur à laquelle le boîtier est soumis dans la suite du processus d'encapsulation ou lors de l'utilisation du circuit intégré. Elles risquent alors de provoquer des cassures de la couche d'isolement 8 ou 9. Ces risques de cassures entraînent que l'on ne peut placer de trous métallisés à l'aplomb de la puce 1. En effet, l'apparition de cassures pourrait endommager la puce elle-même. De telles cassures sont également préjudiciables à l'isolement de la face inférieure de la plaquette 2 qui est réalisé au moyen de la couche 8.

Les bossages de raccordement du premier type de boîtier décrit dans le document EP-A-0 536 418 sont parfois réalisés de telle manière qu'ils remplissent les trous métallisés. Mais, dans ce cas, les bossages sont obligatoirement au niveau des trous métallisés. De plus, cela complique considérablement le procédé de réalisation de la plaquette en imposant des étapes de dépôt et de gravure supplémentaires.

Un autre inconvénient que l'on retrouve dans les deux types de boîtier décrits ci-dessus est lié à l'accrochage du matériau d'encapsulation qui est moulé sur la face supérieure de la plaquette. En effet, la cohésion du boîtier, plus précisément de la résine époxy avec la plaquette n'est assurée que par l'enrobage des fils conducteurs 5 par la résine époxy. Ces fils étant particulièrement fins et fragiles, le boîtier est sensible aux chocs qui risquent d'endommager les connexions entre la puce et la plaquette.

La présente invention vise à pallier ces inconvénients en proposant un boîtier de circuit intégré, utilisant une plaquette de circuit imprimé dont une face inférieure est munie d'un réseau de billes de raccordement, qui élimine tout risque de rupture d'isolement de la face inférieure de la plaquette. L'invention vise également à permettre la présence de trous métallisés sous la puce.

L'invention vise également à assurer un accrochage du matériau d'encapsulation qui soit indépendant de la puce de circuit intégré et de ses fils de connexion avec la plaquette.

L'invention vise également à permettre la réalisation d'un tel boîtier sans accroître le nombre d'étapes par rapport aux procédés de fabrication connus et sans augmenter le coût de fabrication. L'invention vise notamment à respecter la séparation entre une phase de réalisation d'une plaquette destinée à recevoir une puce de circuit intégré et une phase de montage de la puce et d'encapsulation.

Pour atteindre ces objets, la présente invention prévoit un boîtier de circuit intégré comprenant :
- une plaquette isolante munie de trous traversants métallisés reliés à des pistes conductrices, les pistes conductrices d'une face inférieure menant à des premiers plots destinés à recevoir des billes de raccordement propres à être fondues lors du montage du boîtier sur une carte électronique, les pistes conductrices d'une face supérieure menant à des seconds plots connectés à des bornes d'une puce de circuit intégré ;
- ladite puce collée sur la face supérieure de la plaquette ;
- un matériau d'encapsulation enrobant la puce ;
- une première couche d'isolement déposée sur la surface inférieure de la plaquette et ouverte en regard desdits premiers plots ;
- une seconde couche d'isolement déposée sur la surface supérieure de la plaquette et ouverte en regard desdits seconds plots, la plaquette comportant des trous traversants à l'aplomb de la puce, ladite seconde couche d'isolement étant ouverte en regard de ces trous, et de la colle d'accrochage de la puce étant présente dans ces trous.

Selon un mode de réalisation de la présente invention, la plaquette comporte des trous hors de l'aplomb de la puce, la seconde couche d'isolement est entièrement ouverte sous le matériau d'encapsulation, au moins dans une zone dans laquelle sont formés lesdits trous traversants, et du matériau d'encapsulation étant présent dans ces trous.

Selon un mode de réalisation de la présente invention, les couches d'isolement sont constituées de résine photosensible.

Selon un mode de réalisation de la présente invention, le matériau d'encapsulation est une résine époxy.

Selon un mode de réalisation de la présente invention, la colle d'accrochage de la puce est thermiquement conductrice.

L'invention concerne également un procédé de montage d'une puce de circuit intégré comprenant une première phase de réalisation d'une plaquette destinée à recevoir la puce de circuit intégré et une seconde phase de montage et d'encapsulation de la puce, ladite première phase comprenant les étapes suivantes :
- réalisation de trous traversants métallisés dans une plaquette isolante revêtue de couches conductrices sur ces deux faces ;
- gravure desdites couches conductrices sur les deux faces de la plaquette, selon un motif de pistes de connexion des trous métallisés, à des premiers plots de connexion à des billes de raccordement en face inférieure, et à des seconds plots de connexion à des bornes d'une puce de circuit intégré en face supérieure ;
- dépôt d'une première et d'une deuxième couches de résine photosensible isolante, respectivement sur les faces inférieure et supérieure de la plaquette et ouverture de ladite première couche en regard desdits premiers plots et de ladite seconde couche en regard desdits second plots ; et
ladite seconde phase comprenant les étapes suivantes :
- collage de la puce au moyen d'une couche de colle ;
- réalisation des connexions des bornes de la puce auxdits seconds plots, au moyen de fils conducteurs ;
- encapsulation dans une résine époxy ;
- dépôt de billes de raccordement en face inférieure de la plaquette sur lesdits premiers plots ;
ladite seconde couche de résine photosensible étant ouverte, lors de ladite première phase, au moins en regard desdits trous traversants.

Selon un mode de réalisation de la présente invention, ladite seconde couche de résine photosensible est ouverte dans toute une zone de la plaquette dans laquelle sont ménagés des trous traversants et qui est destinée à être revêtue de résine époxy ou de colle.

Selon un mode de réalisation de la présente invention, le procédé consiste à réaliser des trous métallisés à l'aplomb de la puce.

Selon un mode de réalisation de la présente invention, ladite première phase comporte en outre une étape de dépôt électrolytique d'un matériau à haute conductivité, au moins sur les plots de connexion et sur la surface interne des trous métallisés.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 décrite précédemment est destinée à exposer l'état de la technique et le problème posé ;
la figure 2 représente, partiellement et en coupe, un mode de réalisation d'un boîtier, selon l'invention ; et
les figures 3A à 3F représentent, partiellement et en coupe, différentes étapes d'un mode de mise en oeuvre du procédé d'encapsulation selon l'invention.

Les représentations des figures ne sont pas à l'échelle pour des raisons de clarté.

Le boîtier selon l'invention tel que représenté à la figure 2 se distingue des boîtiers classiques essentiellement par une absence de couche d'isolement 19 aux emplacements de trous métallisés 13, en face supérieure d'une plaquette 2 qui reçoit une puce 1 de circuit intégré.

Plus généralement la structure d'encapsulation selon l'invention peut ne comporter d'isolant 19 en face supérieure de la plaquette 2, qu'à l'extérieur d'une zone couverte par un matériau d'encapsulation 21, par exemple une résine époxy. Seule une faible partie 23 de la couche d'isolement supérieure 19 est alors prévue pour être présente sous la périphérie de la résine époxy 21 afin de garantir une jonction isolante entre la couche 19 et le matériau d'encapsulation 21. La puce 1 est montée sur la plaque dans une zone de réception qui lui est destinée. La couche d'isolement 19 est ouverte dans cette zone de réception de la puce 1.

Des trous métallisés 13 sont disposés sous la puce 1 (dans la zone de réception de la puce 1), et le cas échéant hors de l'aplomb de la puce 1 (hors de la zone de réception de la puce 1). Ces trous 13 se trouvent remplis, sous la puce 1, par de la colle 20 d'accrochage de la puce 1, et hors de la puce 1, par de la résine époxy 21 d'encapsulation. On obtient ce résultat car à la fois la colle 20 d'accrochage de la puce 1 et le matériau d'encapsulation 21 sont plus fluides que la résine photosensible utilisée pour former les couches d'isolement 18 et 19. De plus, la colle 20 et la résine 21 sont appliquées sous pression. Pour le collage, on applique de préférence une force et un glissement à la puce lors de sa mise en place. Pour la résine, la pression d'injection dans un moule est de préférence maintenue pendant la solidification. Il n'y a donc plus de risque à prévoir des trous métallisés 13 et des billes de raccordement 17 sous la puce 1. Cela permet de réduire la surface de la plaquette 2 ou, à surface égale, de disposer d'un plus grand nombre de billes de raccordement 17.

On améliore également l'accrochage de la colle 20 (donc de la puce 1) et de la résine d'encapsulation 21 sur la plaquette 2. En effet, les trous 13 constituent pour ces matériaux, des points d'ancrage. La cohésion du boîtier est donc, selon l'invention assurée par l'accrochage du matériau d'encapsulation 21 sur la plaquette 2, indépendamment de la puce 1 et des fils de liaison 5 entre la puce de circuit intégré et la plaquette.

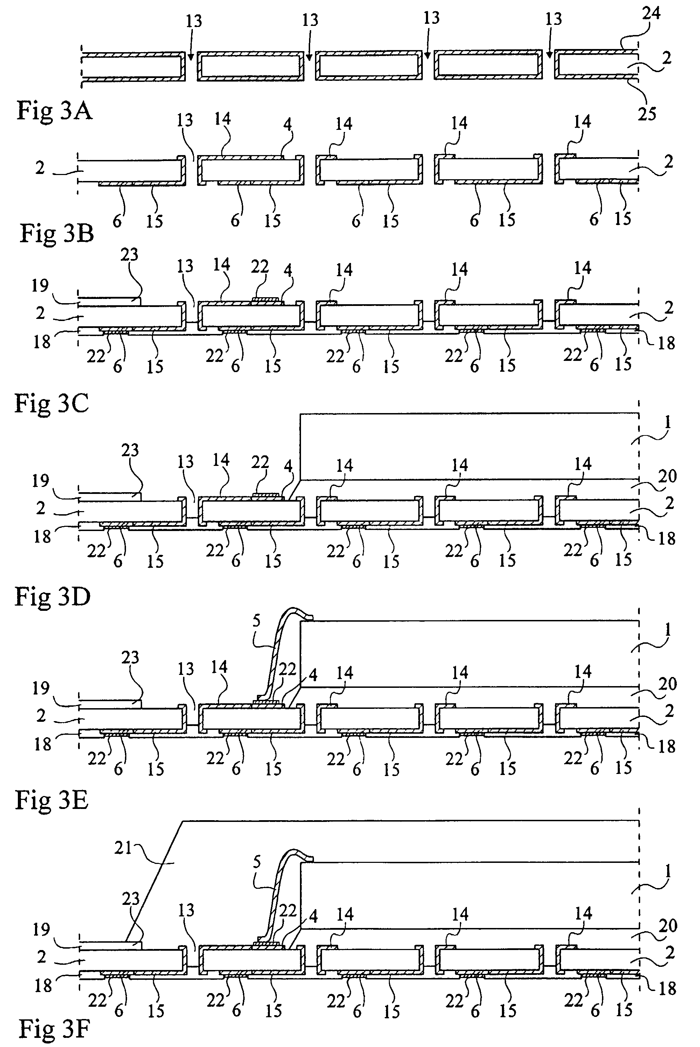

On décrira ci-après un exemple de mode de mise en oeuvre d'un procédé de montage de circuit intégré selon l'invention. Cet exemple est illustré par les figures 3A à 3F qui illustrent différentes étapes de ce procédé.

Selon l'invention, le procédé de montage respecte les deux phases classiques de fabrication. Une première phase concerne la réalisation d'une plaquette destinée à recevoir une puce de circuit intégré. Une deuxième phase concerne le montage proprement dit de la puce et l'encapsulation.

Dans une première étape de la première phase (figure 3A), on perce mécaniquement aux emplacements futurs des trous métallisés 13, la plaquette isolante 2 revêtue sur ses deux faces d'une couche conductrice, respectivement 24 et 25, par exemple en cuivre, et on métallise les trous, par exemple avec du cuivre.

Dans une deuxième étape (figure 3B), on grave, par exemple chimiquement, les couches conductrices 24 et 25 de façon à créer les pistes 14 et 15 et les plots de connexion 4 et 6, respectivement en face supérieure et inférieure de la plaquette 2.

Dans une troisième étape (figure 3C), on dépose pleine plaque, sur les faces inférieure et supérieure de la plaquette 2, respectivement une première 18 et seconde 19 couche de résine photosensible isolante. Puis on ouvre la première couche 18, aux emplacements futurs des billes 17 sur les plots 6 et, la seconde couche 19 aux moins aux emplacements des trous métallisés 13 et des plots 4. Préférentiellement, la couche supérieure de résine photosensible 19 est ouverte sur toute la zone destinée à être recouverte ultérieurement d'une résine époxy 21. Seule une faible partie 23 de la couche d'isolement supérieur 19 est alors prévue pour être présente sous la périphérie de la résine époxy 21.

Afin d'améliorer les contacts entre, respectivement, les fils 5 ou les billes 17 qui seront apposés ultérieurement et leurs plots de connexion respectifs 4 ou 6, on peut effectuer un dépôt électrolytique hautement conducteur 22 sur les deux faces de la plaquette 2, au cours d'une quatrième étape éventuelle. Ce dépôt est, par exemple, constitué de nickel et d'or. Ce dépôt est présent, en face inférieure, sur les plots 6 aux emplacements des ouvertures pratiquées dans la couche de résine photosensible 18 et, en face supérieure, au moins sur les plots 4 et sur les faces internes des trous métallisés 13.

La plaquette 2 est désormais prête à recevoir une puce de circuit intégré 1.

Dans une première étape de la deuxième phase (figure 3D), la puce 1 est collée au moyen d'une couche de colle 20. La colle 20 pénètre par capillarité dans les trous métallisés 13 qui sont en dessous de la puce 1. On favorise ainsi l'accrochage de la couche de colle 20 tout en évitant la formation de bulles d'air dans les trous 13. De préférence, la colle 20 est thermiquement conductrice.

Dans une deuxième étape (figure 3E), on réalise les connexions entre les plots 4 de la face supérieure et les bornes de la puce 1 au moyen de fils conducteurs 5, par exemple de fils d'or. Compte tenu du plan de coupe des figures, un seul fil 5 est représenté. En pratique, des fils 5 seront présents sur tous les cotés de la puce 1.

Puis on encapsule l'ensemble dans une résine époxy 21 au cours d'une troisième étape (figure 3F). Comme dans le cas de la colle 20, la résine époxy 21 pénètre par capillarité dans les trous 13 situés à l'extérieur de la puce 1.

Enfin, dans une quatrième et dernière étape, on forme des billes 17 sur les plots 6 de la face inférieure de la plaquette 2, aux emplacements où la résine photosensible de la première couche 18 a été ôtée. Ces billes 17 sont constituées d'un matériau de soudure, par exemple à l'étain, pour être fondues lors de l'implantation du boîtier sur une carte électronique. On obtient ainsi un boîtier tel que celui représenté à la figure 2.

L'invention permet d'éliminer tout risque d'endommagement de la puce 1 ou de la couche de résine photosensible 18 ou 19, sous l'effet d'une dilatation de l'air humide contenu dans les trous traversants 3 des structures connues.

Un avantage de la présente invention est qu'elle ne nécessite aucune étape de fabrication supplémentaire par rapport aux procédés connus pour réaliser un boîtier à billes de raccordement en matériau de soudure. Un autre avantage de la présente invention est qu'elle respecte la séparation des phases de réalisation du boîtier en une phase de préparation de la plaquette et une phase de montage et d'encapsulation. Cela est particulièrement intéressant dans la mesure où la réalisation de la plaquette et le montage de la puce sont souvent effectués sur des chaînes de fabrication distinctes, voire par des industries différentes.

Bien entendu, la présente invention est susceptible de diverses variantes et modifications qui apparaîtront à l'homme de l'art. En particulier, chacun des constituants décrits pour les couches pourra être remplacé par un ou plusieurs constituants présentant les mêmes caractéristiques et/ou remplissant la même fonction.

En outre, la succession des étapes donnée à titre d'exemple peut être modifiée selon les matériaux et moyens de dépôt et/ou gravure utilisés.

Si les trous métallisés 13 disposés sous la puce 1 doivent être reliés à des bornes distinctes, la colle 20 sera choisie électriquement isolante. Dans le cas où tous ces trous 13 seraient reliés à un même plan de masse, la colle 20 pourra être électriquement conductrice.

Dans le cas où la plaquette 2 est d'une épaisseur telle que l'on craint qu'il subsiste de très petites bulles d'air dans les trous 13 après encapsulation, on pourra procéder à un perçage de la couche d'isolement 18 en face inférieure au niveau des trous 13, par exemple au moyen d'un outillage constitué d'un réseau de pointes. Un tel perçage est rendu possible par le fait que les billes de raccordement 17 ne sont pas disposées en regard des trous 13. De plus, un tel perçage ne nuit pas à l'isolement en face inférieure de la plaquette 2 dans la mesure où le perçage est alors contrôlé pour être effectué dans des zones où la couche d'isolement 18 recouvre déjà un matériau isolant (le matériau d'encapsulation 21 ou la colle 20).

## Revendications

1. Boîtier de circuit intégré comprenant :
- une plaquette isolante (2), sur la face supérieure de laquelle est collée une puce (1) de circuit intégré et dont la face inférieure comporte un réseau de billes (17) de raccordement, chaque bille étant rapportée sur un premier plot (6) relié, par des pistes conductrices (14, 15) des faces supérieure et inférieure de la plaquette et par un trou traversant (13) métallisé, à un second plot (4) connecté à une borne de la puce ;
- un matériau d'encapsulation (21) enrobant la puce (1) ;
- une première couche d'isolement (18) déposée sur la face inférieure de la plaquette (2) et ouverte en regard desdits premiers plots (6) ;
- une seconde couche d'isolement (19) déposée sur la face supérieure de la plaquette (2) et ouverte en regard desdits seconds plots (4),
caractérisé en ce que la plaquette (2) comporte, au moins à l'aplomb de la puce (1), des trous traversants (13) métallisés, ladite seconde couche d'isolement (19) étant ouverte en regard de ces trous (13), et de la colle (20) d'accrochage de la puce (1) étant présente dans ces trous (13).

2. Boîtier de circuit intégré selon la revendication 1, caractérisé en ce que la plaquette (2) comporte des trous traversants (13) métallisés hors de l'aplomb de la puce (1), la seconde couche d'isolement (19) étant ouverte en regard de ces trous et du matériau d'encapsulation (21) étant présent dans ces trous.

3. Boîtier de circuit intégré selon la revendication 1 ou 2, caractérisé en ce que la seconde couche d'isolement (19) est entièrement ouverte sous le matériau d'encapsulation (21), dans une zone dans laquelle sont formés lesdits trous traversants (13).

4. Boîtier de circuit intégré selon l'une quelconque des revendications 1 à 3, caractérisé en ce que les couches d'isolement (18, 19) sont constituées de résine photosensible.

5. Boîtier de circuit intégré selon l'une quelconque des revendications 1 à 4, caractérisé en ce que le matériau d'encapsulation (21) est une résine époxy.

6. Boîtier de circuit intégré selon l'une quelconque des revendications 1 à 5, caractérisé en ce que la colle (20) d'accrochage de la puce (1) est thermiquement conductrice.

7. Procédé de montage d'une puce de circuit intégré comprenant une première phase de réalisation d'une plaquette (2) destinée à recevoir la puce de circuit intégré (1) et une seconde phase de montage et d'encapsulation de la puce (1), ladite première phase comprenant les étapes suivantes :
- réalisation de trous traversants métallisés (13) dans une plaquette isolante (2) revêtue de couches conductrices (24, 25) sur ses deux faces ;
- gravure desdites couches conductrices (24, 25) sur les deux faces de la plaquette (2), selon un motif de pistes (15, 14) de connexion des trous métallisés (13), à des premiers plots (6) de connexion à des billes de raccordement (17) en face inférieure, et à des seconds plots (4) de connexion à des bornes d'une puce (1) de circuit intégré en face supérieure ;
- dépôt d'une première (18) et d'une deuxième (19) couches de résine photosensible isolante, respectivement sur les faces inférieure et supérieure de la plaquette (2) et ouverture de ladite première couche (18) en regard desdits premiers plots (6) et de ladite seconde couche (19) en regard desdits second plots (4) ; et
ladite seconde phase comprenant les étapes suivantes :
- collage de la puce (1) au moyen d'une couche de colle (20) ;
- réalisation des connexions des bornes de la puce (1) auxdits seconds plots (4), au moyen de fils conducteurs (5) ;
- encapsulation dans une résine époxy (21) ;
- dépôt de billes de raccordement (17) en face inférieure de la plaquette (2) sur lesdits premiers plots (6) ;
caractérisé en ce qu'il consiste, lors de la première phase, à réaliser des trous métallisés (13) au moins à l'aplomb de la puce (1) et à ouvrir ladite seconde couche de résine photosensible (19) au moins en regard desdits trous traversants (13) pour que de la colle de la puce soit présente dans ces trous.

8. Procédé de montage de circuit intégré selon la revendication 7, caractérisé en ce que ladite seconde couche de résine photosensible (19) est ouverte dans toute une zone de la plaquette (2) dans laquelle sont ménagés des trous traversants (13) et qui est destinée à être revêtue de résine époxy (21) ou de colle (20).

9. Procédé de montage de circuit intégré selon la revendication 7 ou 8, caractérisé en ce que ladite première phase comporte en outre une étape de dépôt électrolytique d'un matériau à haute conductivité (22), au moins sur les plots de connexion (4, 6) et sur la surface interne des trous métallisés (13).

## Patentansprüche

1. Gehäuse für integrierte Schaltungen umfassend:
- eine Isolierplatte (2), mit deren Oberseite ein integrierter Schaltungschip (1) verklebt ist und deren Unterseite ein Netz bzw. Raster von Anschlußverbindungs-Kugeln (17) aufweist, wobei jeweils jede Kugel auf einem ersten Anschlußkissen bzw. -fleck (6) vorgesehen ist, der bzw. das seinerseits über Leiterbahnen (14,15) auf der Ober- und der Unterseite der Platte und über eine metallisierte Durchgangsöffnung (13), mit einem zweiten Anschlußkissen bzw. -fleck (4) verbunden ist, das bzw. der mit einem Anschluß des Chips verbunden ist;
- ein den Chip (1) umhüllendes einbettendes Kapselungsmaterial (21);
- eine erste, auf der Unterseite der Platte (2) abgeschiedene, in Ausrichtung mit den genannten ersten Anschlußkissen (6) unterbrochene Isolierschicht (18);
- eine zweite, auf der Oberseite der Platte (2) abgeschiedene und in Ausrichtung mit den genannten zweiten Anschlußkissen (4) unterbrochene Isolierschicht (19);
**dadurch gekennzeichnet**, daß die Platte (2) wenigstens unterhalb dem Chip (1) metallisierte Durchgangsöffnungen (13) aufweist, wobei die genannnte zweite Isolierschicht (19) in Ausrichtung mit diesen Durchgangsöffnungen (13) unterbrochen ist und Befestigungskleber (20) des Chips in diesen Durchgangsöffnungen vorliegt.

2. Gehäuse nach Anspruch 1 für integrierte Schaltungen, dadurch gekennzeichnet, daß die Platte (2) metallisierte Durchgangsöffnungen (13) außerhalb des Bereichs unter der Projektion des Chips (1) aufweist, wobei die zweite Isolierschicht (19) in Ausrichtung mit diesen Durchgangsöffnungen unterbrochen ist und in diesen Durchgangsöffnungen Kapselungsmaterial (21) vorliegt.

3. Gehäuse nach den Ansprüchen 1 oder 2, dadurch gekennzeichnet, daß die zweite Isolierschicht (19) unter dem Kapselungsmaterial (21) ganz unterbrochen bzw. entfernt ist, in einer Zone, in welcher die genannten Durchgangsöffnungen (13) ausgebildet sind.

4. Gehäuse nach einem der Ansprüche 1 bis 3, für integrierte Schaltungen, dadurch gekennzeichnet, daß die Isolierschichten (18,19) aus lichtempfindlichem Kunstharz bestehen.

5. Gehäuse nach einem der Ansprüche 1 bis 4, für integrierte Schaltungen, dadurch gekennzeichnet, daß das Kapselungsmaterial (21) ein Epoxyharz ist.

6. Gehäuse nach einem der Ansprüche 1 bis 5, für integrierte Schaltungen, dadurch gekennzeichnet, daß der Befestigungskleber (20) für den Chip (1) wärmeleitend ist.

7. Verfahren zur Montage eines integrierten Schaltungschips, mit einer ersten Phase zur Herstellung einer zur Aufnahme des integrierten Schaltungschips (1) bestimmten Platte (2) und mit einer zweiten Phase zur Montage und Kapselung des Chips (1), wobei die genannte erste Phase die folgenden Verfahrensstufen bzw. -schritte umfaßt:
- in einer auf ihren beiden Seiten mit Leiterschichten (24,25) überzogenen Isolierplatte (2) werden metallisierte Durchgangsöffnungen hergestellt;
- die genannnten Leiterschichten (24,25) auf den beiden Seiten der Platte (2) werden gemäß einem Muster von Bahnen (14,15) geätzt, welche die metallisierten Durchgangsöffnungen (13) mit ersten Anschluß-bzw. Verbindungskissen bzw. -flecken (6) zur Verbindung mit Anschlußkugeln (17) auf der Unterseite, sowie mit zweiten Anschluß-bzw. Verbindungskissen bzw. -flecken (4) zur Verbindung mit Anschlüssen eines integrierten Schaltungschips (1) auf der Oberseite verbinden;
- auf der Ober- bzw. Unterseite der Platte (2) werden eine erste (18) bzw. eine zweite (19) Schicht aus einem lichtempfindlichen isolierenden Harz abgeschieden und die genannte erste Schicht (18) in Ausrichtung mit den genannten Anschlußkissen bzw. -flecken (6) und die genannte zweite Schicht (19) in Ausrichtung mit den genannten zweiten Anschlußkissen bzw. flecken (4) unterbrochen bzw. entfernt;
und wobei die genannte zweite Phase die folgenden Stufen bzw. Schritte umfaßt:
- Verkleben des Chips (1) mittels einer Klebschicht (20)
- Herstellen der Verbindung zwischen den Anschlüssen des Chips (1) mit den genannten zweiten Anschlußkissen bzw. -flecken (4), mithilfe von Leiterfäden;
- Verkapseln in einem Epoxyharz;
- Abscheiden von Anschlußverbindungs-Kugeln (17) auf der Unterseite der Platte (2) auf den genannten ersten Anschlußkissen bzw. -flecken (6);
**dadurch gekennzeichnet**, daß das Verfahren während der ersten Phase die Herstellung der metallisierten Durchgangsöffnungen (13) wenigstens unterhalb dem Chip (1) sowie die Unterbrechung bzw. Entfernung der genannnten zweiten lichtempfindlichen Harzschicht (19) wenigstens in Ausrichtung mit den genannten Durchgangsöffnungen (13) vorsieht, damit Kleber des Chips in den Durchgangsöffnungen vorliegt.

8. Verfahren zur Montage einer integrierten Schaltung, nach Anspruch 7, dadurch gekennzeichnet, daß die genannte zweite lichtempfindliche Harzschicht (19) in der ganzen Zone der Platte (2) unterbrochen bzw. entfernt wird, in welcher Durchgangsöffnungen angebracht werden und die mit Epoxyharz (21) oder mit Kleber (20) überzogen werden soll.

9. Verfahren zur Montage einer integrierten Schaltung, nach Anspruch 7 oder 8, dadurch gekennzeichnet, daß die genannte erste Phase des weiteren eine Stufe bzw. einen Schritt der elektrolytischen Abscheidung eines Materials hoher Leitfähigkeit (22) wenigstens auf den Anschlußkissen bzw. -flecken (4,6) und auf der Innenfläche der metallisierten Durchgangsöffnungen (13) umfaßt.

## Claims

1. An integrated circuit casing comprising:
- an insulating plate (2), on the upper surface of which is glued on integrated circuit chip (1) and the lower surface of which comprises an array of connection balls (17), each ball being disposed on a first pad (6) connected, through conductive tracks (14, 15) of the upper and lower surfaces of the plate and a metallized through hole (13), to a second pad (4) connected to a terminal of the chip;
- an encapsulation material (21) embedding the chip (1);
- a first insulating layer (18) deposited on the lower surface of the plate (2) and etched away in front of said first pads (6);
- a second insulating layer (19) deposited on the upper surface of the plate (2) and etched away in front of said second pads (4);
characterized in that the plate (2) comprises, at least under the chip (1), metallized through holes (13), said second insulating layer (19) being etched away in front of said holes (13), and glue (20) anchoring the chip (1) being present in said holes (13).

2. The casing of claim 1, characterized in that the plate (2) includes metallized through holes (13) outside the projection of the chip (1), the second insulating layer (19) being etched away in front of said holes and encapsulation material (21) being present in said holes.

3. The casing of claim 1 or 2, characterized in that the second insulating layer (19) is entirely etched away beneath the encapsulation material (21) in an area in which are formed said through holes (13).

4. The casing of any of claims 1 to 3, characterized in that the insulating layers (18, 19) are made of a photoresist.

5. The casing of any of claims 1 to 4, characterized in that the encapsulation material (21) is an epoxy resin.

6. The casing of any of claims 1 to 5, characterized in that the glue (20) anchoring the chip (1) is thermally conductive.

7. A process for mounting an integrated circuit chip including a first phase of manufacturing a plate (2) adapted to receive the integrated circuit chip (1) and a second phase of mounting and encapsulating the chip (1), said first phase including the following steps:
- forming metallized through holes (13) in an insulating plate (2) covered by conductive layers (24, 25) on its both surfaces;
- etching said conductive layers (24, 25) on the two surfaces of the plate (2), according to a pattern of tracks (15, 14) for connecting the metallized holes (13), to first pads (6) for connection to connecting balls (17) in the lower surface, and to second pads (4) for connection to terminals of said integrated circuit chip (1) on the upper surface;
- depositing a first (18) and a second (19) insulating photoresist layers, respectively, on the lower and upper surfaces of the plate (2) and etching away said first layer (18) in front of said first pads (6) and said second layer (19) in front of said second pads (4); and
said second phase including the following steps:
- anchoring the chip (1) with a layer of glue (20);
- connecting the terminals of the chip (1) to said second pads (4), through conductive wires (5);
- encapsulating in an epoxy resin (21);
- depositing connection balls (17) on the lower surface of the plate (2) over said first pads (6);
characterized in that it includes, during the first phase, the formation of the metallized holes (13) at least under the chip (1) and the etching of said second photoresist layer (19) at least in front of said through holes (13) so that the glue of the chip is present in said holes.

8. The process of claim 7, characterized in that said second photoresist layer (19) is etched away in all a portion of the plate (2) in which are formed through holes (13) and which is designed to be coated with an epoxy resin (21) or with the glue (20).

9. The process of claim 7 or 8, characterized in that the first phase further includes the step of electrolytically depositing a high conductivity material (22) at least over the connection pads (4, 6) and the inner surface of the holes (13).
